# EUROPÄISCHE PATENTSCHRIFT

(11) **EP 1 987 591 B1**
(45) Veröffentlichungstag und Bekanntmachung des Hinweises auf die Patenterteilung: **14.10.2009**
(21) Anmeldenummer: 07726404.2
(22) Anmeldetag: 16.02.2007
(51) Int. Cl.: H03K 17/0412, H03K 17/687

(54) **SCHALTUNG ZUM SCHALTEN EINES SPANNUNGSGESTEUERTEN TRANSISTORS**
CIRCUIT FOR SWITCHING A VOLTAGE-CONTROLLED TRANSISTOR
CIRCUIT POUR COMMUTER UN TRANSISTOR COMMANDÉ EN TENSION

(30) Priorität: 21.02.2006 DE 202006002762 U
(43) Veröffentlichungstag der Anmeldung: 05.11.2008
(73) Patentinhaber: Osram Gesellschaft mit beschränkter Haftung, 81543 München (DE)
(72) Erfinder: FISCHER, Klaus, 86316 Friedberg (DE); KREITTMAYR, Josef, 86399 Bobingen (DE)
(86) Internationale Anmeldenummer: PCT/EP2007/051515
(87) Internationale Veröffentlichungsnummer: WO 2007/096305

(56) Entgegenhaltungen:
- DE-A1- 3 712 998
- DE-A1- 19 638 619
- GB-A- 2 238 437
- JP-A- 6 244 698

## Beschreibung

### Technisches Gebiet

Die vorliegende Erfindung bezieht sich auf eine Schaltung mit einem spannungsgesteuerten Transistor, der geschaltet werden soll.

### Stand der Technik

Spannungsgesteuerte Transistoren sind bekannt und finden vielfach Verwendung. Diese können beispielsweise als FET, insbesondere MOSFET, oder IGBT ausgeführt sein. Spannungsgesteuerte Transistoren weisen einen Steuereingang auf, welcher in Abhängigkeit von seiner Spannung gegenüber einem Referenzpotenzial Einfluss auf die Schaltstrecke des Transistors nimmt. Beispielsweise kann eine negative Aufladung des Steuereingangs (Gate beim MOSFET) die Bewegungen von Leitungselektronen durch die Schaltstrecke des Transistors (zwischen Drain und Source) unterbinden und somit den Transistor sperren bzw., wenn man diesen als Schalter betrachtet, öffnen.

Häufig werden spannungsgesteuerte Transistoren zum Schalten größerer Leistungen verwendet. Die Schaltzeitpunkte werden üblicherweise jedoch über eine signalverarbeitende Elektronik mit nur einem geringen Leistungsumsatz bestimmt. Die Steuereingänge von spannungsgesteuerten Transistoren lassen sich aufgrund ihrer Eingangskapazität von entsprechend schwachen Signalen nicht beliebig schnell schalten.

Zum Schalten der spannungsgesteuerten Leistungstransistoren wird daher üblicherweise eine (Treiber-)Schaltung verwendet, welche durch die schwachen Signale getriggert wird. Dazu verfügen solche Schaltungen über eine eigene Leistungsversorgung, welche sie zur Generierung entsprechend starker Schaltsignale brauchen.

Exemplarisch wird hier eine einfach Schaltung zum Schalten eines spannungsgesteuerten Transistors mit einem Operationsverstärker vorgestellt. Sie umfasst einen Operationsverstärker mit einem Open-Collector-Ausgang, an dem einer von zwei Zuständen vorliegen kann. In dem einen Zustand ist der Ausgang des Operationsverstärkers niederohmig mit einem Bezugspotenzial verbunden, in dem anderen Zustand ist der Ausgang des Operationsverstärkers hochohmig von diesem getrennt. Diese Zustände kann man als logisch Null und logisch Eins bezeichnen. Zum Schalten eines spannungsgesteuerten Transistors kann eine Gleichspannungsversorgung verwendet werden. Dabei ist zwischen ein Versorgungspotenzial einer Gleichspannungsversorgung und den Ausgang des Operationsverstärkers ein erster Widerstand, ein sog. "Pull-up-Widerstand" geschaltet. Der Ausgang des Operationsverstärkers ist mit dem Steuereingang des spannungsgesteuerten Transistors verbunden. Ist der Ausgang des Operationsverstärkers niederohmig (logisch Null), so wird der Steuereingang des spannungsgesteuerten Transistors über den Operationsverstärker auf das Bezugspotenzial umgeladen. Ist der Ausgang des Operationsverstärkers hochohmig (logisch Eins), so ist der Steuereingang des spannungsgesteuerten Transistors über den "Pull-up-Widerstand" mit dem Versorgungspotenzial der Gleichspannungsversorgung verbunden und kann über diese umgeladen werden. Je nach Polarität der Gleichspannungsversorgung und Aufbau des spannungsgesteuerten Transistors kann dies einem Ein- oder Ausschalten der Schaltstrecke desselben entsprechen.

Eine Schaltung gemäß Oberbegriff des Anspruchs 1 ist aus dem Dokument DE-A-37 12 998 bekannt.

### Darstellung der Erfindung

Der vorliegenden Erfindung liegt die Aufgabe zugrunde, eine bzgl. des Schaltens eines spannungsgesteuerten Transistors verbesserte Schaltung anzugeben.

Diese Aufgabe wird gelöst durch eine Schaltung mit einem spannungsgesteuerten Transistor, welche Schaltung aufweist ein erstes und ein zweites Versorgungspotenzial, einen ersten und einen zweiten Transistor und eine Impedanz, wobei eine Serienschaltung der Schaltstrecke des ersten Transistors und der Impedanz zwischen das erste Versorgungspotenzial und den Steuereingang des spannungsgesteuerten Transistors geschaltet ist, wobei die Impedanz dem ersten Versorgungspotenzial zugewandt geschaltet ist, das erste Versorgungspotenzial über die Schaltstrecke des zweiten Transistors mit dem Steuereingang des ersten Transistors verbunden ist, der Steuereingang des zweiten Transistors so mit einem Verbindungsknoten zwischen der Impedanz und der Schaltstrecke des ersten Transistors verschaltet ist, dass eine Potenzialänderung an dem Verbindungsknoten den zweiten Transistor schalten kann, und wobei die Schaltung so ausgelegt ist, dass durch ein über ein Steuersignal vermitteltes Einschalten des ersten Transistors ein erster Strom durch die Serienschaltung fließt und beginnt den Steuereingang des spannungsgesteuerten Transistors in einem ersten Sinn umzuladen, der erste Strom durch die Serienschaltung eine erste Potenzialverschiebung an dem Verbindungsknoten bewirkt, durch diese erste Potenzialverschiebung der zweite Transistor eingeschaltet wird und daher ein zweiter Strom durch die Schaltstrecke des zweiten Transistors in den Steuereingang des ersten Transistors fließt, welcher den ersten Strom verstärkt, die zunehmende Umladung des Steuereingangs des spannungsgesteuerten Transistors eine zweite Potenzialverschiebung an dem Verbindungsknoten bewirkt, der zweite Transistor durch diese zweite Potenzialverschiebung ausgeschaltet wird, und der erste Transistor jedoch eingeschaltet bleibt und den spannungsgesteuerten Transistor in seinem neuen Schaltzustand hält. Bei der Schaltung ist zwischen den Verbindungsknoten (V1) und den Steuereingang des zweiten Transistors (T2) ein erster Kondensator (C1) geschaltet, welcher durch die erste Potenzialverschiebung über einen zu dem ersten Kondensator (C1) seriellen Widerstand (R3) so umgeladen wird, dass dieser ein Ausschalten des zweiten Transistors (T2) durch die zweite Potenzialverschiebung unterstützt.

Bevorzugte Ausgestaltungen der Erfindung sind in den abhängigen Ansprüchen angegeben und werden im Folgenden erläutert.

Die Erfindung beruht auf der bereits erwähnten Tatsache, dass als Leistungsschalter ausgelegte spannungsgesteuerte Transistoren eine große Eingangskapazität an ihrem Steuereingang aufweisen. Selbst in Kombination mit in einer (Treiber-)Schaltung vorhandenen Widerständen können große Umladezeitkonstanten entstehen, aufgrund derer der Steuereingang des spannungsgesteuerten Transistors nicht ausreichend schnell umgeladen werden kann. Weiter kann es sein, dass in der Schaltung vorhandene Widerstände, wie beispielsweise der oben erwähnte Pull-up-Widerstand, nicht beliebig klein gestaltet werden können.

Die Erfindung geht von dem Ziel aus, für das Umladen des Steuereingangs eines spannungsgesteuerten Transistors einen niederohmigen Umladepfad freizuschalten. Allerdings kann sich ein niederohmiger Umladepfad auch störend auf die Betriebssicherheit bzw. Betriebsqualität einer den spannungsgesteuerten Transistor ansteuernden Schaltung auswirken. Ist beispielsweise der niederohmige Umladepfad zum Aufladen des kapazitiven Steuereinganges freigeschaltet, so besteht eine niederohmige Verbindung zwischen einem der Versorgungspotenziale und dem Steuereingang des spannungsgesteuerten Transistors, um diesen schnell aufzuladen. Bleibt die niederohmige Verbindung zwischen dem eben genannten Versorgungspotenzial und dem Steuereingang erhalten, während der Steuereingang entladen wird, so kann es zu einem Kurzschluss zwischen den beiden Versorgungspotenzialen kommen.

Die Erfinder haben dies erkannt und daher beruht die Erfindung auf der weiteren Idee, nicht nur einen niederohmigen Umladepfad freizuschalten, sondern diesen auch so auszulegen, dass bei einem erneuten gegensinnigen Umladen nicht ein niederohmiger Strompfad zwischen den Versorgungspotenzialen entsteht.

Erfindungsgemäß wird durch ein über ein Steuersignal vermitteltes Einschalten des ersten Transistors dem Steuereingang des spannungsgesteuerten Transistors ein erster Strom zugeführt. Das Steuersignal kann beispielsweise von einem Operationsverstärker mit Open-Collector-Ausgang durch ein Wechseln des Ausgangswiderstandes von niederohmig zu hochohmig in Verbindung mit einem Pull-up-Widerstand erzeugt werden.

Die Schaltstrecke des ersten Transistors ist zusammen mit einer Impedanz in Serie zwischen das erste Versorgungspotenzial und den Steuereingang des spannungsgesteuerten Transistors geschaltet. Aufgrund des nun durch den ersten Transistor fließenden Stromes verschiebt sich das Potenzial zwischen dem ersten Transistor und der dem ersten Versorgungspotenzial zugewandt geschalteten Impedanz in Richtung des zweiten Versorgungspotenzials. Der Steuereingang des zweiten Transistors ist mit dem Verbindungsknoten zwischen der Impedanz und dem ersten Transistor verschaltet, so dass diese erste Potenzialverschiebung den zweiten Transistor einschaltet. Da die Schaltstrecke des zweiten Transistors zwischen das erste Versorgungspotenzial und den Steuereingang des ersten Transistors geschaltet ist, ist nun ein insgesamt sehr niederohmiger Umladepfad freigeschaltet. Der Strom durch die Schaltstrecke des zweiten Transistors verstärkt den Strom durch die Schaltstrecke des ersten Transistors. Die Eingangskapazität des spannungsgesteuerten Transistors kann so sehr schnell umgeladen werden. Die zunehmende Umladung des Steuereingangs des spannungsgesteuerten Transistors führt nun allerdings dazu, dass sich das Potenzial an dem Knoten zwischen dem ersten Transistor und der zu diesem in Serie geschalteten Impedanz wieder in Richtung des ersten Versorgungspotenzials verschiebt. Durch diese zweite Potenzialverschiebung wird der zweite Transistor wieder ausgeschaltet.

Der niederohmige Pfad durch den zweiten Transistor zu dem Steuereingang des ersten Transistors hat so durch das durch ihn mitbewirkte schnelle Aufladen des Steuereingangs des spannungsgesteuerten Transistors seine eigene Abschaltung mit verursacht. Der erste Transistor bleibt jedoch eingeschaltet, so dass der spannungsgesteuerte Transistor in seinem neuen Schaltzustand verbleibt.

Wird nun beispielsweise die Eingangskapazität des spannungsgesteuerten Transistors über den niederohmig geschalteten Ausgang eines Operationsverstärkers mit Open-Collector-Ausgang gegensinnig umgeladen, so stellt der Pfad durch den zweiten Transistor keinen niederohmigen Pfad für einen Kurzschluss der Versorgungsspannunq dar.

Weiterhin weist eine erfindungsgemäße Schaltung einen zwischen den oben erwähnten Verbindungsknoten (zwischen dem ersten Transistor und der dazu seriellen Impedanz) und den Steuereingang des zweiten Transistors geschalteten ersten Kondensator auf, welcher durch die erste Potenzialverschiebung in Folge des Einschaltens des ersten Transistors so über einen zu dem ersten Kondensator seriellen Widerstand umgeladen wird, dass dieser ein Ausschalten des zweiten Transistors durch die zweite Potenzialverschiebung in Folge der fortschreitenden Umladung der Eingangskapazität des spannungsgesteuerten Transistors unterstützt. Dazu kann der erste Kondensator mit dem Steuereingang des zweiten Transistors verschaltet sein und der zu dem ersten Kondensator in Serie geschaltete Widerstand zwischen den ersten Kondensator und den Verbindungsknoten.

Für schnelle Spannungsänderungen stellt der erste Kondensator einen Kurzschluss dar. Daher wird der zweite Transistor im Anschluss an das Einschalten des ersten Transistors unmittelbar eingeschaltet.

Die Kapazität des ersten Kondensators und der Widerstand des in Serie zu dem ersten Kondensator geschalteten Widerstands wird so gewählt, dass der erste Kondensator in der Zeit geladen werden kann, in der der Steuereingang des spannungsgesteuerten Transistors ausreichend umgeladen ist. Der in Serie zu dem ersten Kondensator geschaltete Widerstand verhindert dabei ein zu schnelles Umladen des ersten Kondensators. Würde der erste Kondensator zu schnell umgeladen, so würde der zweite Transistor frühzeitig wieder ausgeschaltet werden und die Beschleunigung des Schaltens des spannungsgesteuerten Transistors durch den zweiten Transistor wäre unterbunden oder zumindest nicht so groß wie möglich.

Der erste Kondensator unterstützt das Ausschalten des zweiten Transistors wie folgt: Sind anfangs der erste und der zweite Transistor geöffnet, so liegt der Verbindungsknoten und damit der Steuereingang des zweiten Transistors auf dem Potenzial des ersten Versorgungspotenzials. Wird der erste Transistor eingeschaltet, so verschiebt sich das Potenzial des Verbindungsknotens in Richtung des zweiten Versorgungspotenzials. Der zwischen den Verbindungsknoten und den Steuereingang des zweiten Transistors geschaltete erste Kondensator wird dabei über den in Serie geschalteten Widerstand umgeladen. Durch die zweite Potenzialverschiebung an dem Verbindungsknoten wird jedoch das Laden des ersten Kondensators beendet und die Spannung an dem Steuereingang des zweiten Transistors bewegt sich wieder auf das erste Versorgungspotenzial zu. Durch die bereits erfolgte Umladung des ersten Kondensators kann das Potenzial an dem Steuereingang des zweiten Transistors den Bereich zwischen dem ersten und zweiten Versorgungspotenzial verlassen und in Richtung des ersten Versorgungspotenzials über dieses hinausgehen. Ist beispielsweise das erste Versorgungspotenzial positiv und das zweite Versorgungspotenzial negativ, so kann an dem Steuereingang des zweiten Transistors nach der zweiten Potenzialverschiebung ein Potenzial anliegen, welches höher ist als das positive Versorgungspotenzial.

Ist in diesem Beispiel der zweite Transistor etwa ein pnp-Transistor, dessen Emitter an das positive Versorgungspotenzial und dessen Basis an den ersten Kondensator angeschlossen ist, so liegt nach der zweiten Potenzialverschiebung über der Basis-Emitter-Diode eine negative Spannung an. Der zweite Transistor sperrt dann sicher und wird schnell entsättigt.

Eine schnelle Entsättigung ist vorteilhaft, da bei einem erneuten gegensinnigen Schalten des spannungsgesteuerten Transistors die in dem zweiten Transistor verbliebenen Ladungsträger einen Kurzschlussstrom zwischen den Versorgungspotenzialen begründen können (s. Ausführungsbeispiel).

Tritt ein Gateleckstrom vom Steuereingang des spannungsgesteuerten Transistors zum zweiten Versorgungspotenzial auf, so kann das Potenzial an dem Verbindungsknoten nicht das erste Versorgungspotenzial erreichen. Durch die Umladung des ersten Kondensators kann dennoch ein sicheres Ausschalten des zweiten Transistors gewährleistet sein.

Es kann ein Widerstand zwischen den Steuereingang des zweiten Transistors und das erste Versorgungspotenzial geschaltet sein (s. auch die Ausführungen zu Anspruch 9).

Ist kein Kondensator zwischen den Steuereingang des zweiten Transistors und den Verbindungsknoten geschaltet und tritt ein Gateleckstrom auf, so fällt aufgrund des Gateleckstroms an diesem Widerstand dauerhaft eine Spannung ab, was zu einem unbeabsichtigten dauerhaften Einschalten des zweiten Transistors führen kann. Ist der erste Kondensator in Serie zu diesem Widerstand geschaltet, so verursacht der Gateleckstrom aufgrund des Umladens des ersten Kondensators langfristig keinen Spannungsabfall mehr an diesem Widerstand.

Der eben erwähnte Widerstand ist so ausgelegt, dass an ihm in Folge des durch ihn fließenden Stroms aufgrund der ersten Potenzialverschiebung ein ausreichend großer Spannungsabfall zum Einschalten des zweiten Transistors erzeugt wird.

Der Schwellwert eines Bipolartransistors kann temperaturabhängig sein. Beispielsweise beträgt bei einem bipolaren pnp-Transistor der Schwellwert bei -30°C etwa 0,8 V, während er bei 130°C etwa 0,4 V beträgt.

Um in diesem Beispiel, ohne Kondensator zwischen dem Steuereingang des zweiten Transistors und dem Verbindungsknoten, auch bei maximalem Schwellwert ein sicheres Einschalten des Bipolartransistors zu gewährleisten, müsste der zwischen den Steuereingang des zweiten Transistors und das erste Versorgungspotenzial geschaltete Widerstand vergleichsweise hochohmig sein. Dies kann allerdings dazu führen, dass bei anderen Temperaturen, wenn der Schwellwert des zweiten Transistors geringer ist, dieser zu leicht eingeschaltet wird. Wäre der erste Kondensator nicht zwischen den Steuereingang des zweiten Transistors und den Verbindungsknoten geschaltet, so könnten eventuell bereits kleinere Gateleckströme durch diesen Widerstand den zweiten Transistor einschalten. Ist er jedoch vorhanden, so unterbindet er im aufgeladenen Zustand den Einfluss eines eventuellen Gateleckstromes.

Vorzugsweise ist der zu dem ersten Kondensator in Serie geschaltete Widerstand so ausgelegt, dass die Ladezeit des ersten Kondensators kleiner ist als die minimale Verweildauer des spannungsgesteuerten Transistors in dem neuen Schaltzustand. Der zweite Transistor wird so sicher ausgeschaltet, bevor der spannungsgesteuerte Transistor wieder (gegensinnig) umgeschaltet wird.

Ein eventueller (je nach Schaltungsanordnung, s. Ausführungsbeispiele) Kurzschluss zwischen den Versorgungspotenzialen durch die Schaltstrecke des zweiten Transistors und eine Schaltstrecke zum Ausschalten des spannungsgesteuerten Transistors kann so auch bei kurzen Verweildauern des spannungsgesteuerten Transistors in seinen Schaltzuständen verhindert werden. Es ist vorteilhaft, auch die Ausräumzeit des zweiten Transistors zu beachten und die Summe aus der Ladezeit des ersten Kondensators und der Ausräumzeit des zweiten Transistors kleiner als die minimale Verweildauer des spannungsgesteuerten Transistors in dem neuen Schaltzustand zu wählen.

Dazu kann auch hier der erste Kondensator mit dem Steuereingang des zweiten Transistors verschaltet sein und der zu dem ersten Kondensator in Serie geschaltete Widerstand zwischen dem ersten Kondensator und dem Verbindungsknoten liegen.

Vorzugsweise wird der erste Transistor über einen Open-Collector-Ausgang eines Operationsverstärkers und einen Pull-up-Widerstand eingeschaltet. Kleine Transistoren wie der erste oder der zweite Transistor können so einfach und zuverlässig geschaltet werden.

Wird für den ersten Transistor etwa ein Bipolartransistor gewählt, dessen Kollektor mit dem Verbindungsknoten verschaltet ist und dessen Emitter mit dem Steuereingang des spannungsgesteuerten Transistors verschaltet ist, so bewegt sich beim Umladen der Eingangskapazität des spannungsgesteuerten Transistors in dem zweiten Sinn und der damit verbundenen schnellen Potenzialverschiebung an Emitter und Basis des ersten Transistors in Richtung des zweiten Versorgungspotenzials auch das Potenzial an dem Kollektor des ersten Transistors schnell in Richtung des zweiten Versorgungspotenzials. Eine solche Potenzialverschiebung kann zu einem erneuten unerwünschten Einschalten des zweiten Transistors führen..

Vorzugsweise weist deshalb die erfindungsgemäße Schaltung einen dritten Transistor auf, dessen Steuereingang kapazitiv mit dem Steuereingang des spannungsgesteuerten Transistors verschaltet ist und dessen Schaltstrecke in Serie zwischen dem ersten Versorgungspotenzial und dem Steuereingang des zweiten Transistors liegt, so dass bei einer Potenzialverschiebung in Richtung des zweiten Versorgungspotenzials an dem Steuereingang des spannungsgesteuerten Transistors der dritte Transistor über seinen Steuereingang eingeschaltet wird und ein unerwünschtes Einschalten des zweiten Transistors verhindert wird.

Die Schaltstrecke des dritten Transistors kann unmittelbar mit dem Steuereingang des zweiten Transistors verschaltet sein; in diesem Fall kann der dritte Transistor die eben beschriebene Funktion ausführen.

Die Schaltstrecke des dritten Transistors kann aber auch zwischen das erste Versorgungspotenzial und den Verbindungsknoten zwischen dem ersten Transistor und der zwischen dem ersten Versorgungspotenzial und dem ersten Transistor liegenden Impedanz geschaltet sein. In diesem Fall kann der dritte Transistor die oben beschriebene Funktion ausführen und außerdem die Entladung des ersten Kondensators verbessern. Ist hier der zu dem ersten Kondensator seriell geschaltete Widerstand dem Verbindungsknoten zugewandt geschaltet, so wird der Transistor über diesen Widerstand und die Schaltstrecke des dritten Transistors entladen.

Bei einer bevorzugten Ausführungsform der Erfindung ist der erste Kondensator dem Steuereingang des zweiten Transistors zugewandt geschaltet und der zu dem ersten Kondensator seriell geschaltete Widerstand ist dem Verbindungsknoten zugewandt geschaltet. Die Schaltstrecke des dritten Transistors ist zwischen das erste Versorgungspotenzial und einen Knoten zwischen dem ersten Kondensator und dem Widerstand geschaltet. Ist die Schaltstrecke des dritten Transistors so verschaltet, kann dieser die oben beschriebene Funktion ausführen und außerdem den ersten Kondensator niederohmig entladen. Der Entladestrom des ersten Kondensators fließt dabei nicht durch den Widerstand zwischen dem ersten Kondensator und dem Verbindungsknoten.

Vorzugsweise ist der Steuereingang des dritten Transistors über einen zweiten Kondensator mit dem Steuereingang des spannungsgesteuerten Transistors verschaltet. Zur Erhöhung der Störfestigkeit ist ein Widerstand zu dem zweiten Kondensator parallel geschaltet. Über diesen Widerstand kann der dritte Transistor dauerhaft in dem eingeschalteten Zustand gehalten werden, solange die Eingangskapazität des spannungsgesteuerten Transistors nicht wieder in dem ersten Sinn umgeladen wird.

Zum Entladen des zweiten Kondensators ist vorzugsweise zwischen den Steuereingang des dritten Transistors und das erste Versorgungspotenzial eine erste Diode geschaltet. Diese erste Diode verhindert außerdem, dass die Spannung zwischen dem Steuereingang des dritten Transistors und dem ersten Versorgungspotenzial beim Umladen der Eingangskapazität des spannungsgesteuerten Transistors in dem ersten Sinn unzulässige Werte erreichen kann. Ist der dritte Transistor etwa ein Bipolartransistor und der Emitter des dritten Transistors mit dem ersten Versorgungspotenzial verschaltet, so kann durch die erste Diode ein Erreichen der Durchbruchspannung der Basis-Emitter-Diode des dritten Transistors verhindert werden.

Zur Verbesserung der Entladung des ersten Kondensators ist vorzugsweise zwischen den Steuereingang des zweiten Transistors und das erste Versorgungspotential eine zweite Diode geschaltet. Die zweite Diode verhindert auch, dass die Basis-Emitterspannung des zweiten Transistors unzulässige Werte annehmen kann.

Vorzugsweise ist ein Widerstand zwischen den Steuereingang des zweiten Transistors und das erste Versorgungspotenzial geschaltet. Dies erhöht die Störsicherheit der Schaltung, da ohne einen solchen Widerstand bereits kleinste Ströme in der Leitung, mit der der Steuereingang des zweiten Transistors verschaltet ist, ein Einschalten desselben auslösen können. Um ein Einschalten des zweiten Transistors zu ermöglichen, muss durch den Widerstand ein bestimmter Mindeststrom fließen. Weiter kann der in Serie zu dem Steuereingang des zweiten Transistors geschaltete erste Kondensator auch über diesen Widerstand entladen werden.

Bei einer bevorzugten Ausführungsform der Erfindung ist ein vierter Transistor mit seiner Schaltstrecke zwischen den Steuereingang des spannungsgesteuerten Transistors und das zweite Versorgungspotenzial geschaltet. Dabei ist der Steuereingang des vierten Transistors so mit dem O-pen-Collector-Ausgang des Operationsverstärkers verschaltet, dass der Open-Collector-Ausgang den vierten Transistor einschalten kann, um über die Schaltstrecke des vierten Transistors den Steuereingang des spannungsgesteuerten Transistors in dem verbleibenden zweiten Sinn umzuladen.

Wird beispielsweise die Eingangskapazität des spannungsgesteuerten Transistors über die erfindungsgemäße Schaltung mit dem ersten und dem zweiten Transistor geladen, so wird diese nun mit Hilfe des vierten Transistors entladen. Zum Entladen wird die Stromverstärkung des vierten Transistors ausgenutzt, so dass die Eingangskapazität des spannungsgesteuerten Transistors mit einem Strom umgeladen werden kann, welcher durch die Stromtragfähigkeit des Operationsverstärkerausgangs und die Stromverstärkung des vierten Transistors bestimmt ist.

Das Umladen der Eingangskapazität des spannungsgesteuerten Transistors mit Hilfe des vierten Transistors erlaubt zwar eine effiziente Umladung (in dem zweiten Sinn) der Eingangskapazität, erfordert jedoch einen Transistor. Daher weist die Schaltung bei einer anderen bevorzugten Ausführungsform eine dritte Diode auf. Die dritte Diode ist so mit dem Steuereingang des spannungsgesteuerten Transistors verschaltet, dass sie zwischen den Steuereingang des spannungsgesteuerten Transistors und das zweite Versorgungspotenzial über eine Schaltstrecke geschaltet werden kann, um die Eingangskapazität des spannungsgesteuerten Transistors in dem zweiten Sinn umzuladen. Wird der erste Transistor etwa über einen Operationsverstärker mit Open-Collector-Ausgang angesteuert, kann die dritte Diode zwischen den Steuereingang des spannungsgesteuerten Transistors und den Open-Collector-Ausgang des Operationsverstärkers geschaltet sein.

Vorzugsweise ist zumindest einer der Transistoren aus der Gruppe aus dem ersten, dem zweiten, dem dritten und dem vierten Transistor ein Bipolartransistor, besonders bevorzugter Weise alle. Bipolartransistoren sind besonders billig.

Die vorstehende und nachfolgende Beschreibung der einzelnen Merkmale bezieht sich auf die erfindungsgemäße Schaltung. Weiter bezieht sie sich auf ein der Erfindung entsprechendes Verfahren zum Schalten eines spannungsgesteuerten Transistors. Dies gilt auch, ohne dass es im Einzelnen noch explizit erwähnt wird.

Die Erfindung bezieht sich also grundsätzlich auch auf ein Verfahren zum Schalten eines spannungsgesteuerten Transistors mit einer Schaltung, welche den spannungsgesteuerten Transistor, ein erstes und ein zweites Versorgungspotenzial, einen ersten und einen zweiten Transistor und eine Impedanz aufweist, wobei eine Serienschaltung der Schaltstrecke des ersten Transistors und der Impedanz zwischen das erste Versorgungspotenzial und den Steuereingang des spannungsgesteuerten Transistors geschaltet ist, wobei die Impedanz dem ersten Versorgungspotenzial zugewandt geschaltet ist, das erste Versorgungspotenzial über die Schaltstrecke des zweiten Transistors mit dem Steuereingang des ersten Transistors verbunden ist, der Steuereingang des zweiten Transistors so mit einem Verbindungsknoten zwischen der Impedanz und der Schaltstrecke des ersten Transistors verschaltet ist, dass eine Potenzialänderung an dem Verbindungsknoten den zweiten Transistor schalten kann, und das Verfahren folgende Schritte aufweist, Einschalten des ersten Transistors über ein Steuersignal, Umladen des Steuereingangs des spannungsgesteuerten Transistors in einem ersten Sinn mit einem ersten durch die Serienschaltung fließenden Strom, Bewirken einer ersten Potenzialverschiebung durch den ersten Strom durch die Serienschaltung an dem Verbindungsknoten, Einschalten des zweiten Transistors durch diese erste Potenzialverschiebung, Verstärken des ersten Stromes durch einen durch die Schaltstrecke des zweiten Transistors in den Steuereingang des ersten Transistors fließenden zweiten Strom, Bewirken einer zweiten Potenzialverschiebung an dem Verbindungsknoten durch die zunehmende Umladung des Steuereingangs des spannungsgesteuerten Transistors, Ausschalten des zweiten Transistors durch diese zweite Potenzialverschiebung und Halten des spannungsgesteuerten Transistors in seinem neuen Schaltzustand durch Halten des ersten Transistors im eingeschalteten Zustand.

### Kurze Beschreibung der Zeichnungen

Im Folgenden soll die Erfindung anhand von Ausführungsbeispielen näher erläutert werden. Die dabei offenbarten Einzelmerkmale können auch in anderen Kombinationen erfindungswesentlich sein.
Figur 1 zeigt das Schaltbild einer erfindungsgemäßen Schaltung als erstes Ausführungsbeispiel.
Figur 2 zeigt das Schaltbild einer Variation der Schaltung aus Figur 1 als zweites Ausführungsbeispiel.
Figur 3 zeigt das Schaltbild einer weiteren Variation der Schaltung aus Figur 1 als drittes Ausführungsbeispiel.

### Bevorzugte Ausführung der Erfindung

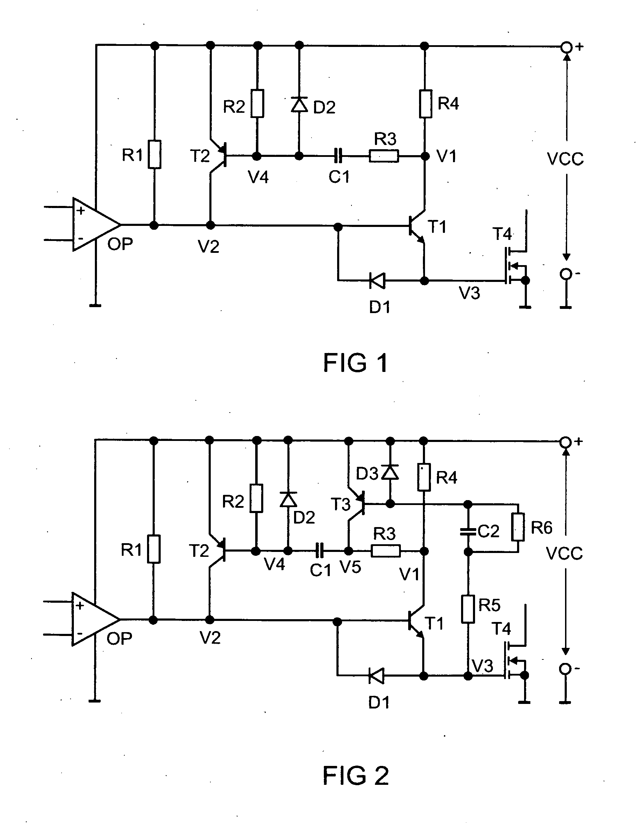

Figur 1 zeigt das Schaltbild einer erfindungsgemäßen Schaltung mit einem spannungsgesteuerten Transistor T4. Die Schaltung wird über eine ein positives und ein negatives Versorgungspotenzial aufweisende Gleichspannung versorgt. Die Gleichspannungsversorgung dient hier auch zur Versorgung eines Operationsverstärkers OP, welcher einen invertierenden und einen nicht invertierenden Eingang aufweist, über den er von einer signalverarbeitenden Schaltung (nicht gezeigt) Signale erhält. Der Ausgang des Operationsverstärkers OP kann hier zwei Zustände annehmen: einen hochohmigen (logisch Eins) und einen niederohmigen (logisch Null), wobei sich hochohmig bzw. niederohmig jeweils auf die Leitfähigkeit des Operationsverstärkers OP vom Ausgang zum Bezugspotenzial, hier dem negativen Versorgungspotenzial, bezieht.

Zwischen das positive und das negative Versorgungspotenzial sind seriell ein erster Widerstand R1, eine Diode D1 und die Gate-Source-Strecke des spannungsgesteuerten Transistors T4, hier ein MOSFET, geschaltet. Der Söurce-Anschluss des MOSFET ist dabei mit dem negativen Versorgungspotenzial verbunden.

Der Ausgang des Operationsverstärkers OP ist mit einem Verbindungsknoten V2 zwischen der Diode D1 und dem ersten Widerstand R1 verbunden.

Zwischen das positive Versorgungspotenzial und einen Verbindungsknoten V3 zwischen der Diode D1 und dem Steuereingang des spannungsgesteuerten Transistors T4 ist eine Serienschaltung aus einem Widerstand R4 und der Kollektor-Emitterstrecke eines ersten Bipolartransistors (npn) T1 geschaltet. Die Basis des ersten Transistors T1 ist ebenfalls mit dem Verbindungsknoten V2 verbunden. Zwischen das positive Versorgungspotenzial und die Basis des ersten Transistors T1 ist die Emitter-Kollektorstrecke eines zweiten Transistors (pnp) T2 geschaltet. Die Basis des zweiten Transistors T2 ist dabei über eine Serienschaltung aus einem Kondensator C1 und einem Widerstand R3 mit einem Verbindungsknoten V1 zwischen dem Widerstand R4 und dem ersten Transistor T1 verbunden. Ein Widerstand R2 ist zwischen das positive Versorgungspotenzial und einen Verbindungsknoten V4 zwischen der Basis des zweiten Transistors T2 und dem Kondensator C1 geschaltet. Parallel zu dem Widerstand R2 ist eine Diode D2 geschaltet. Über diese Diode D2 wird das Entladen des Kondensators C1 verbessert.

Der spannungsgesteuerte Transistor T4 wird durch positives Aufladen seines Steuereingangs, d. h. Gates, eingeschaltet, d. h. seine Schaltstrecke (Drain/ Source) leitet. Vor dem Einschalten des spannungsgesteuerten Transistors T4 ist der Ausgang des Operationsverstärkers OP logisch Null, d. h., dass die Gatekapazität des MOSFET T4 über die Diode D1 und den Ausgang des Operationsverstärkers OP entladen wurde. Der erste Transistor T1 sperrt. Der Kondensator C1 ist entladen, da beide Seiten auf positivem Versorgungspotenzial liegen. Auch der zweite Transistor T2 sperrt, da sowohl dessen Emitter, als auch dessen Basis auf dem positiven Versorgungspotenzial liegen.

Soll der spannungsgesteuerte Transistor T4 eingeschaltet werden, so wird der Ausgang des Operationsverstärkers OP hochohmig (logisch Eins). Das Potenzial an dem Verbindungsknoten V2 wird durch den Pull-up-Widerstand R1 angehoben. Damit steigt auch die Spannung über der Basis-Emitterstrecke des ersten Transistors T1 und schaltet diesen ein. Ein Strom durch den Widerstand R4 und die Kollektor-Emitterstrecke des ersten Transistors T1 beginnt zu fließen, so dass die Gatekapazität des spannungsgesteuerten Transistors T4 aufgeladen wird.

Durch den Stromfluss durch den Widerstand R4 fällt das Potenzial an dem Kollektor des ersten Transistors T1, d. h. an dem Verbindungsknoten V1. Dieser Potenzialabfall erfasst über den Kondensator C1 und den Widerstand R3 die Basis des zweiten Transistors T2. Die Spannung über dem Kondensator C1 kann sich nicht sprungartig verändern, daher entspricht die Spannungsänderung an der Basis des zweiten Transistors T2 zum Zeitpunkt des Einschaltens des ersten Transistors T1 in einem kurzen Zeitraum der Spannungsänderung an dem basisseitigen Anschluss des Widerstandes R3.

Der Emitter des zweiten Transistors T2 liegt auf dem positiven Versorgungspotenzial. Sobald die über der Basis-Emitterstrecke des zweiten Transistors T2 abfallende Spannung dessen Schwellwert erreicht, wird auch der zweite Transistor T2 eingeschaltet und beginnt einen Kollektorstrom zu führen. Der Kollektorstrom des zweiten Transistors T2 wird auf die Basis des ersten Transistors T1 geführt, beschleunigt dadurch dessen Einschalten und verstärkt den in die Gatekapazität des spannungsgesteuerten Transistors T4 geleiteten Strom.

Wird C1 als Kurzschluss betrachtet und R3 vernachlässigt, so bilden die beiden Transistoren T1 und T2 hier einen Thyristor, welcher durch eine positive Spannung an der Basis des ersten Transistors T1 gezündet wird. Durch das Zünden des Thyristors T1, T2 wird die Gatekapazität des spannungsgesteuerten Transistors T4 sehr schnell geladen.

Mit zunehmender Aufladung der Gatekapazität des spannungsgesteuerten Transistors T4 steigt auch das Potenzial an dem Verbindungsknoten V3 bzw. an dem Emitter des ersten Transistors T1 und an dem Kollektor des ersten Transistors T1 bzw. an dem Verbindungsknoten V1. Dies führt über den Widerstand R3 und den Kondensator C1 dazu, dass die Basis-Emitterspannung des zweiten Transistors T2 unter dessen Schwellwert fällt und dieser wieder ausgeschaltet wird. Das Ausschalten des zweiten Transistors T2 erfolgt allerdings nicht instantan, sondern erst nach Entsättigung seiner Halbleitergrenzschichten.

Wenn der Transistor T2 ausgeschaltet ist, bleibt der Steuereingang des spannungsgesteuerten Transistors T4 über den eingeschalteten ersten Transistor T1, den Pull-up-Widerstand R1 und das positive Versorgungspotenzial eingeschaltet.

Der zweite Transistor T2 beschleunigt also zunächst das Umladen der Gatekapazität des spannungsgesteuerten Transistors T4. Spätestens nach der vollständigen Umladung wird der für die zusätzliche Verstärkung verwendete zweite Transistor T2 wieder ausgeschaltet. Der Thyristor aus dem ersten und dem zweiten Transistor T1, T2 ist nun gelöscht.

Zum Ausschalten des spannungsgesteuerten Transistors T4 stellt der Ausgang des Operationsverstärkers OP eine niederohmige Verbindung zum negativen Versorgungspotenzial her. Dadurch wird die Gatekapazität des spannungsgesteuerten Transistors T4 über die Diode D1 entladen. Der zweite Transistor T2 ist bereits ausgeschaltet und führt keinen Kollektorstrom. Daher wird der Ausgang des Operationsverstärkers OP lediglich mit dem Strom durch den Pull-up-Widerstand R1 und mit dem Strom, welcher zur Entladung der Gatekapazität des spannungsgesteuerten Transistors T4 erforderlich ist, beaufschlagt. Die Basis-Emitterspannung des ersten Transistors T1 ist negativ und der erste Transistor T1 sperrt. Es treten - insbesondere über die Schaltstrecke des zweiten Transistors - keine Kurzschlussströme zwischen dem positiven und dem negativen Versorgungspotenzial auf.

Der Kondensator C1 verbessert den Betrieb der erfindungsgemäßen Schaltung. Während die Gatekapazität des spannungsgesteuerten Transistors T4 geladen wird und die Spannung an dem Verbindungsknoten V1 niedriger als das positive Versorgungspotenzial ist, wird der Kondensator C1 über den Widerstand R3 geladen. Durch die zunehmende Aufladung der Gatekapazität des spannungsgesteuerten Transistors T4 steigt das Potenzial an dem Verbindungspunkt V1 jedoch wieder und das Laden des Kondensators C1 wird beendet. Auch das Potenzial an der Basis des zweiten Transistors T2 steigt wieder an. Somit nimmt dessen Basis-Emitterspannung ab. Da der Kondensator C1 jedoch geladen ist, kann das Potenzial an der Basis des zweiten Transistors über das positive Versorgungspotenzial steigen; der zweite Transistor T2 wird also besonders sicher ausgeschaltet und seine Entsättigung beschleunigt.

Vom Steuereingang des spannungsgesteuerten Transistors T4 zum negativen Versorgungspotenzial kann ein Gateleckstrom auftreten. Dann fließt durch die Schaltstrecke des ersten Transistors T1 nach wie vor ein Strom, wenn auch ein vergleichsweise kleiner, und das Potenzial an dem Verbindungsknoten V1 erreicht nicht vollständig das Niveau des positiven Versorgungspotenzials.

Der Kondensator C1 unterbindet durch seine Umladung den Fluss des ansonsten durch den Widerstand R2 fließenden Teils des Gateleckstromes. Dementsprechend fällt über der Basis-Emitterstrecke des zweiten Transistors T2 keine Spannung ab und dieser wird sicher ausgeschaltet

Weiter ist der komplexe Widerstand des Kondensators C1 für einen bezüglich der Temperatur robusten Betrieb interessant. Der Schwellwert von Bipolartransistoren hängt von der Umgebungstemperatur ab. So liegt der Schwellwert eines pnp-Transistors bei -30 °C bei etwa 0,8 V, während er bei 130 °C bei etwa 0,4 V liegt. Ohne den Kondensator C1 müsste der Widerstand R2 so ausgelegt sein, dass der durch den Widerstand R2 fließende Strom auch bei maximalem Schwellwert des zweiten Transistors T2 an diesem einen ausreichend großen Spannungsabfall erzeugt. Dazu müsste der Widerstand R2 entsprechend hochohmig sein. Wäre der Schwellwert jedoch geringer, würde der zweite Transistor T2 bei einem großen Widerstand R2 zu leicht eingeschaltet, so dass die Schaltung insgesamt störanfällig wird.

Die Ladezeit des Kondensators C1 wird über den Widerstand R3 so eingestellt, dass der Kondensator C1 in der Zeit geladen wird, in der der Steuereingang des MOSFET T4 ausreichend aufgeladen ist. Andererseits ist die Summe aus der Ladezeit des Kondensators C1 und der Ausräumzeit des zweiten Transistors T2 kürzer als die minimale Einschaltdauer des MOSFET T4, so dass bei einem Ausschalten des MOSFET T4 der Ausgang des Operationsverstärkers nicht mit einem durch den zweiten Transistor T2 fließenden Strom beaufschlagt wird.

Figur 2 zeigt das Schaltbild einer Variation der in Figur 1 gezeigten Schaltung. Die in Figur 1 gezeigte Schaltung ist nur leicht modifiziert und um einige Bauteile ergänzt worden. Bauteile, welche hier die gleiche Funktion haben wie in der in Figur 1 gezeigten Schaltung, tragen auch nach wie vor die gleichen Bezugszeichen.

Im Unterschied zu Figur 1 ist parallel zu dem Kondensator C1 und dem Widerstand R2 ein weiterer Transistor T3 geschaltet. Dabei ist sein Emitter an das positive Versorgungspotenzial geschaltet und sein Kollektor an einen Verbindungsknoten V5 zwischen dem Kondensator C1 und dem Widerstand R3. Die Basis des Transistors T3 ist über eine Serienschaltung aus einem Kondensator C2 und einem Widerstand R5 mit dem Steuereingang des spannungsgesteuerten Transistors T4 verbunden. Parallel zu dem Kondensator C2 liegt ein Widerstand R6 und parallel zu der Basis-Emitterstrecke des Transistors T3 eine Diode D3.

Es hat sich herausgestellt, dass beim Abschalten des spannungsgesteuerten Transistors T4 und der damit verbundenen schnellen Abnahme des Potenzials an dem Emitter und der Basis des ersten Transistors T1 auch die Kollektorspannung des ersten Transistors T1 abfällt. Dieser Potenzialabfall kann über den Widerstand R3 und den Kondensator C1 zu einem unerwünschten Einschalten des zweiten Transistors T2 führen. Dies soll der Transistor T3 verhindern. Dazu ist seine Basis kapazitiv mit dem Steuereingang des spannungsgesteuerten Transistors T4 verbunden. Fällt das Potenzial an dem Verbindungsknoten V3, so wird der Transistor T3 über den Kondensator C2 eingeschaltet. Über den Widerstand R2 kann sich dann keine ausreichende Spannung zum Einschalten des zweiten Transistors T2 aufbauen.

Bei einem Anstieg des Potenzials an dem Verbindungsknoten V3, also an dem Steuereingang des spannungsgesteuerten Transistors T4, wird der Transistor T3 ausgeschaltet. Über eine parallel zur Basis-Emitterstrecke des Transistors T3 geschaltete Diode D3 kann der Kondensator C2 entladen werden. Weiter verhindert die Diode D3, dass die Basis-Emitterspannung des Transistors T3 beim Einschalten des spannungsgesteuerten Transistors T4 die Durchbruchspannung der Basis-Emitterdiode des Transistors T3 überschreitet.

Parallel zu dem Kondensator C2 ist ein Widerstand R6 geschaltet, mit dem die Störfestigkeit weiter verbessert werden kann. Über den Widerstand R6 kann der Transistor T3 eingeschaltet bleiben, solange die Gatekapazität des spannungsgesteuerten Transistors T4 entladen ist.

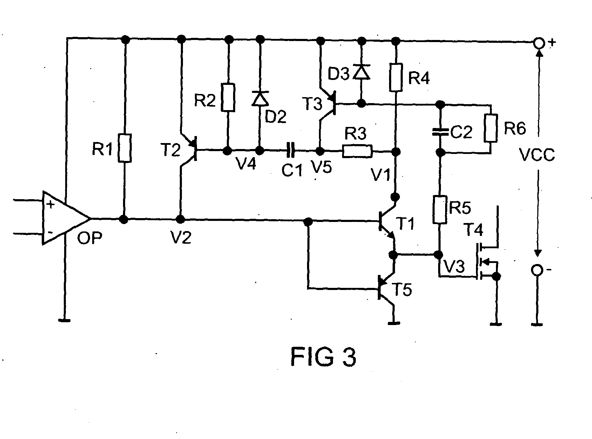

Figur 3 zeigt das Schaltbild einer Variation der in den Figuren 1 bzw. 2 gezeigten Schaltungen. Die in Figur 3 gezeigte Schaltung ist nur leicht modifiziert. Bauteile, welche hier die gleiche Funktion haben wie in den in Figur 1 bzw. Figur 2 gezeigten Schaltungen, tragen auch nach wie vor die gleichen Bezugszeichen.

Im Unterschied zu den Figuren 1 und 2 taucht hier die Diode D1 zum Entladen der Gatekapazität des spannungsgesteuerten Transistors T4 nicht auf. Stattdessen ist die Emitter-Kollektorstrecke eines Transistors T5 zwischen den Steuereingang des spannungsgesteuerten Transistors T4 und das negative Versorgungspotenzial geschaltet. Die Basis des Transistors T5 ist mit dem Ausgang des Operationsverstärkers OP verbunden.

Beim Ausschalten des spannungsgesteuerten Transistors T4 nimmt der Ausgang des Operationsverstärkers OP seinen niederohmigen Zustand an, durch den der Transistor T1 ausgeschaltet wird. Der Transistor T5 wird jedoch eingeschaltet. Die Gatekapazität des spannungsgesteuerten Transistors T4 wird nun im Wesentlichen über die Emitter-Kollektorstrecke des Transistors T5 entladen. Der maximal mögliche Entladestrom entspricht dabei dem Produkt aus der Stromtragfähigkeit des Ausgangs des Operationsverstärkers OP und der Stromverstärkung des Transistors T5.

## Patentansprüche

1. Schaltung mit einem spannungsgesteuerten Transistor (T4), welche Schaltung aufweist:
- ein erstes (+) und ein zweites (-) Versorgungspotenzial (+, -),
- einen ersten (T1) und einen zweiten Transistor (T2) und
- eine Impedanz (R4),
wobei
- eine Serienschaltung (R4, T1) der Schaltstrecke des ersten Transistors (T1) und der Impedanz (R4) zwischen das erste Versorgungspotenzial (+) und den Steuereingang des spannungsgesteuerten Transistors (T4) geschaltet ist, wobei die Impedanz (R4) dem ersten Versorgungspotenzial (+) zugewandt geschaltet ist,
- das erste Versorgungspotenzial (+) über die Schaltstrecke des zweiten Transistors (T2) mit dem Steuereingang des ersten Transistors (T1) verbunden ist,
- der Steuereingang des zweiten Transistors (T2) so mit einem Verbindungsknoten (V1) zwischen der Impedanz (R4) und der Schaltstrecke des ersten Transistors (T1) verschaltet ist, dass eine Potenzialänderung an dem Verbindungsknoten (V1) den zweiten Transistor (T2) schalten kann,
und wobei die Schaltung so ausgelegt ist, dass:
- durch ein über ein Steuersignal vermitteltes Einschalten des ersten Transistors (T1) ein erster Strom durch die Serienschaltung (R4, T1) fließt und beginnt den Steuereingang des spannungsgesteuerten Transistors (T4) in einem ersten Sinn umzuladen,
- der erste Strom durch die Serienschaltung (R4, T1) eine erste Potenzialverschiebung an dem Verbindungsknoten (V1) bewirkt,
- durch diese erste Potenzialverschiebung der zweite Transistor (T2) eingeschaltet wird und daher ein zweiter Strom durch die Schaltstrecke des zweiten Transistors (T2) in den Steuereingang des ersten Transistors (T1) fließt, welcher den ersten Strom verstärkt,
- die zunehmende Umladung des Steuereingangs des spannungsgesteuerten Transistors (T4) eine zweite Potenzialverschiebung an dem Verbindungsknoten (V1) bewirkt,
- der zweite Transistor (T2) durch diese zweite Potenzialverschiebung ausgeschaltet wird,
- und der erste Transistor (T1) jedoch eingeschaltet bleibt und den spannungsgesteuerten Transistor (T4) in seinem neuen Schaltzustand hält
**dadurch gekennzeichnet,**
**dass** die Schaltung einen zwischen den Verbindungsknoten (V1) und den Steuereingang des zweiten Transistors (T2) geschalteten ersten Kondensator (C1) aufweist, welcher durch die erste Potenzialverschiebung über einen zu dem ersten Kondensator (C1) seriellen Widerstand (R3) so umgeladen wird, dass dieser ein Ausschalten des zweiten Transistors (T2) durch die zweite Potenzialverschiebung unterstützt.

2. Schaltung nach Anspruch 1, bei dem der zu dem ersten Kondensator (C1) in Serie geschaltete Widerstand (R3) so ausgelegt ist, dass die Ladezeit des ersten Kondensators (C1) kleiner ist als die minimale Verweildauer des spannungsgesteuerten Transistors (T4) in seinem neuen Schaltzustand.

3. Schaltung nach einem der vorangehenden Ansprüche, welche dazu ausgelegt ist, den ersten Transistor (T1) über einen Open-Collector-Ausgang eines Operationsverstärkers (OP) und einen Pull-up-Widerstand (R1) einzuschalten.

4. Schaltung nach einem der vorangehenden Ansprüche mit einem dritten Transistor (T3) dessen Steuereingang kapazitiv mit dem Steuereingang des spannungsgesteuerten Transistors (T4) verschaltet ist und dessen Schaltstrecke in Serie zwischen dem ersten Versorgungspotenzial (+) und dem Steuereingang des zweiten Transistors (T2) liegt, so dass bei einer Potenzialverschiebung in Richtung des zweiten Versorgungspotenziales (-) am Steuereingang des spannungsgesteuerten Transistors (T4) der dritte Transistor (T3) über seinen Steuereingang eingeschaltet wird und ein Einschalten des zweiten Transistors (T2) verhindert wird.

5. Schaltung nach Anspruch 4, bei dem der erste Kondensator (C1) dem Steuereingang des zweiten Transistors (T2) zugewandt geschaltet ist und der zu dem ersten Kondensator (C1) serielle Widerstand (R3) dem Verbindungsknoten (V1) zwischen der Impedanz (R4) und der Schaltstrecke des ersten Transistors (T1) zugewandt geschaltet ist, und bei dem die Schaltstrecke des dritten Transistors (T3) zwischen das erste Versorgungspotenzial (+) und einen Knoten (V5) zwischen dem ersten Kondensator (C1) und dem Widerstand (R3) geschaltet ist.

6. Schaltung nach Anspruch 4 oder 5, bei der der Steuereingang des dritten Transistors (T3) über einen zweiten Kondensator (C2) mit dem Steuereingang des spannungsgesteuerten Transistors (T4) verschaltet ist und bei der ein Widerstand (R6) zu dem zweiten Kondensator (C2) zur Erhöhung der Störfestigkeit parallel geschaltet ist.

7. Schaltung nach Anspruch 6, bei der eine erste Diode (D3) zum Entladen des zweiten Kondensators (C2) zwischen den Steuereingang des dritten Transistors (T3) und das erste Versorgungspotenzial (+) geschaltet ist.

8. Schaltung nach einem der vorangehenden Ansprüche, bei der eine zweite Diode (D2) zum Entladen des ersten Kondensators (C1) zwischen den Steuereingang des zweiten Transistors (T2) und das erste Versorgungspotential (+) geschaltet ist.

9. Schaltung nach einem der vorangehenden Ansprüche, bei der ein Widerstand (R2) zwischen das erste Versorgungspotenzial und den Steuereingang des zweiten Transistors (T2) geschaltet ist.

10. Schaltung nach Anspruch 3, auch in Kombination mit einem weiteren der vorangehenden Ansprüche, mit einem vierten Transistor (T5) dessen Schaltstrecke zwischen den Steuereingang des spannungsgesteuerten Transistors (T4) und das zweite Versorgungspotenzial (-) geschaltet ist, wobei der Steuereingang des vierten Transistors (T5) so mit dem Open-Collector-Ausgang des Operationsverstärkers (OP) verschaltet ist, dass der Open-Collector-Ausgang den vierten Transistors (T5) einschalten kann, um über die Schaltstrecke des vierten Transistors (T5) den Steuereingang des spannungsgesteuerten Transistors (T4) in dem verbleibenden zweiten Sinn umzuladen.

11. Schaltung nach einem der vorangehenden Ansprüche, mit einer dritten Diode (D1), wobei die Schaltung dazu ausgelegt ist, die dritte Diode (D1) zwischen den Steuereingang des spannungsgesteuerten Transistors (T4) und das zweite Versorgungspotenzial über eine Schaltstrecke zu schalten, um diesen Steuereingang in dem verbleibendem zweiten Sinn umzuladen.

12. Schaltung nach Anspruch 11 und einem der Ansprüche 4 bis 8, auch in Kombination mit einem weiteren der vorstehenden Ansprüche, bei der zumindest ein Transistor aus der Gruppe aus dem ersten (T1), dem zweiten (T2), dem dritten (T3) und dem vierten Transistor (T5) ein Bipolartransistor ist.

## Claims

1. Circuit comprising a voltage-controlled transistor (T4), which circuit has:
- a first (+) and a second (-) supply potential (+,-),
- a first (T1) and a second transistor (T2), and
- an impedance (R4),
wherein
- a series circuit (R4, T1) formed by the switching path of the first transistor (T1) and the impedance (R4) is connected between the first supply potential (+) and the control input of the voltage-controlled transistor (T4), wherein the impedance (R4) is connected in a manner facing the first supply potential (+),
- the first supply potential (+) is connected to the control input of the first transistor (T1) via the switching path of the second transistor (T2),
- the control input of the second transistor (T2) is connected up to a connecting node (V1) between the impedance (R4) and the switching path of the first transistor (T1) in such a way that a potential change at the connecting node (V1) can switch the second transistor (T2),
and wherein the circuit is designed in such a way that:
- as a result of the first transistor (T1) being switched on in a manner mediated by means of a control signal, a first current flows through the series circuit (R4, T1) and starts to subject the control input of the voltage-controlled transistor (T4) to charge reversal in a first sense,
- the first current through the series circuit (R4, T1) brings about a first potential shift at the connecting node (V1),
- the second transistor (T2) is switched on by this first potential shift and a second current therefore flows through the switching path of the second transistor (T2) into the control input of the first transistor (T1), which amplifies the first current,
- the increasing charge reversal of the control input of the voltage-controlled transistor (T4) brings about a second potential shift at the connecting node (V1),
- the second transistor (T2) is switched off by this second potential shift,
- and the first transistor (T1) remains switched on, however, and holds the voltage-controlled transistor (T4) in its new switching state,
**characterized in that** the circuit has a first capacitor (C1) connected between the connecting node (V1) and the control input of the second transistor (T2), which first capacitor is subjected to charge reversal by the first potential shift via a resistor (R3) in series with the first capacitor (C1) in such a way that it supports a switching off of the second transistor (T2) by the second potential shift.

2. Circuit according to Claim 1, in which the resistor (R3) connected in series with the first capacitor (C1) is designed in such a way that the charging time of the first capacitor (C1) is shorter than the minimum duration for which the voltage-controlled transistor (T4) stays in its new switching state.

3. Circuit according to any of the preceding claims, which is designed to switch on the first transistor (T1) via an open collector output of an operational amplifier (OP) and a pull-up resistor (R1).

4. Circuit according to any of the preceding claims, comprising a third transistor (T3), the control input of which is capacitively connected up to the control input of the voltage-controlled transistor (T4) and the switching path of which is connected in series between the first supply potential (+) and the control input of the second transistor (T2), such that in the case of a potential shift in the direction of the second supply potential (-) at the control input of the voltage-controlled transistor (T4), the third transistor (T3) is switched on via its control input and a switching on of the second transistor (T2) is prevented.

5. Circuit according to Claim 4, in which the first capacitor (C1) is connected in a manner facing the control input of the second transistor (T2) and the resistor (R3) in series with the first capacitor (C1) is connected in the manner facing the connecting node (V1) between the impedance (R4) and the switching path of the first transistor (T1), and in which the switching path of the third transistor (T3) is connected between the first supply potential (+) and a node (V5) between the first capacitor (C1) and the resistor (R3).

6. Circuit according to Claim 4 or 5, in which the control input of the third transistor (T3) is connected up to the control input of the voltage-controlled transistor (T4) via a second capacitor (C2), and in which a resistor (R6) is connected in parallel with the second capacitor (C2) in order to increase the interference immunity.

7. Circuit according to Claim 6, in which a first diode (D3) for discharging the second capacitor (C2) is connected between the control input of the third transistor (T3) and the first supply potential (+).

8. Circuit according to any of the preceding claims, in which a second diode (D2) for discharging the first capacitor (C1) is connected between the control input of the second transistor (T2) and the first supply potential (+).

9. Circuit according to any of the preceding claims, in which a resistor (R2) is connected between the first supply potential and the control input of the second transistor (T2).

10. Circuit according to Claim 3, also in combination with a further one of the preceding claims, comprising a fourth transistor (T5), the switching path of which is connected between the control input of the voltage-controlled transistor (T4) and the second supply potential (-), wherein the control input of the fourth transistor (T5) is connected up to the open collector output of the operational amplifier (OP) in such a way that the open collector output can switch on the fourth transistor (T5) in order to subject the control input of the voltage-controlled transistor (T4) to charge reversal in the remaining second sense via the switching path of the fourth transistor (T5).

11. Circuit according to any of the preceding claims, comprising a third diode (D1), wherein the circuit is designed to connect the third diode (D1) between the control input of the voltage-controlled transistor (T4) and the second supply potential via a switching path in order to subject said control input to charge reversal in the remaining second sense.

12. Circuit according to Claim 11 and any of Claims 4 to 8, also in combination with a further one of the preceding claims, in which at least one transistor from the group of the first (T1), the second (T2), the third (T3) and the fourth transistor (T5) is a bipolar transistor.

## Revendications

1. Circuit ayant un transistor ( T4 ) commandé par la tension, ce circuit comportant :
- un premier ( + ) et un deuxième ( - ) potentiels ( +, - ) d'alimentation,
- un premier ( T1 ) et un deuxième transistors ( T2 ) et
- une impédance ( R4 ),
dans lequel
- un circuit ( R4, T1 ) série composé de la section de commutation du premier transistor ( T1 ) et de l'impédance ( R4 ) est monté entre le premier potentiel ( + ) d'alimentation et l'entrée de commande du transistor ( T4 ) commandé par la tension, l'impédance ( R4 ) étant montée du côté tourné vers le premier potentiel ( + ) d'alimentation,
- le premier potentiel ( + ) d'alimentation est relié à l'entrée de commande du premier transistor ( T1 ) par la section de commutation du deuxième transistor ( T2 ),
- l'entrée de commande du deuxième transistor ( T2 ) est reliée à un noeud ( V1 ) de liaison entre l'impédance ( R4 ) et la section de commutation du premier transistor ( T1 ) de sorte qu'une variation de potentiel sur le noeud ( V1 ) de liaison peut mettre le deuxième transistor ( T2 ) à l'état passant,
et dans lequel le circuit est conçu de façon :
- à ce que, par une mise à l'état passant du premier transistor ( T1 ), provoquée par un signal de commande, un premier courant passe dans le circuit ( R4, T1 ) et commence à recharger dans un premier sens l'entrée de commande du transistor ( T4 ) commandé par la tension,
- à ce que le premier courant passant dans le circuit ( R4, T1 ) série provoque un premier décalage de potentiel sur le noeud ( V1 ) de liaison,
- à ce que, par ce premier décalage de potentiel, le deuxième transistor ( T2 ) soit mis à l'état passant et qu'il passe donc, en passant par la section de commutation du deuxième transistor ( T2 ) dans l'entrée de commande du premier transistor ( T1 ) un deuxième courant qui amplifie le premier courant,
- à ce que la recharge croissante de l'entrée de commande du transistor commandé par la tension provoque un deuxième décalage de potentiel sur le noeud ( V1 ) de liaison,
- à ce que le deuxième transistor ( T2 ) soit bloqué par ce deuxième décalage de potentiel,
- et à ce que le premier transistor ( T1 ) reste toutefois à l'état passant et le transistor ( T4 ) commandé par la tension conserve son nouvel état de commutation,
**caractérisé**
**en ce que** le circuit a un premier condensateur ( C1 ) qui est monté entre le noeud ( V1 ) de liaison et l'entrée de commande du deuxième transistor ( T2 ) et qui est rechargé par le premier décalage de potentiel par l'intermédiaire d'une résistance ( R3 ) en série avec le premier condensateur ( C1 ), de façon à ce que cette résistance favorise un blocage du deuxième transistor ( T2 ) par le deuxième décalage de potentiel.

2. Circuit suivant la revendication 1, dans lequel la résistance ( R3 ) montée en série avec le premier condensateur ( C1 ) est conçue de façon à ce que la durée de charge du premier condensateur ( C1 ) soit plus petite que la durée minimum pendant laquelle le transistor ( T4 ) commandé par la tension reste dans son nouvel état de commutation.

3. Circuit suivant l'une des revendications précédentes, qui est conçu de façon à mettre à l'état passant le premier transistor ( T1 ) par une sortie open-collector d'un amplificateur ( OP ) opérationnel et par une résistance ( R1 ) pull-up.

4. Circuit suivant l'une des revendications précédentes, comprenant un troisième transistor ( T3 ) dont l'entrée de commande est reliée capacitivement à l'entrée de commande du transistor ( T4 ) commandé par la tension et dont la section de commutation est en série entre le premier potentiel ( + ) d'alimentation et l'entrée de commande du deuxième transistor ( T2 ) de sorte que, lors d'un décalage de potentiel en direction du deuxième potentiel ( - ) d'alimentation à l'entrée de commande du transistor ( T4 ) commandé par la tension, le troisième transistor ( T3 ) est mis à l'état passant par son entrée de commande et empêche une mise à l'état passant du deuxième transistor ( T2 ).

5. Circuit suivant la revendication 4, dans lequel le premier condensateur ( C1 ) est monté du côté tourné vers l'entrée de commande du deuxième transistor ( T2 ) et la résistance ( R3 ) en série avec le premier condensateur ( C1 ) est montée du côté tourné vers le noeud ( V1 ) de liaison entre l'impédance ( R4 ) et la section de commutation du premier transistor ( T1 ) et dans lequel la section de commutation du troisième transistor ( T3 ) est montée entre le premier potentiel ( + ) d'alimentation et un noeud ( V5 ) entre le premier condensateur ( C1 ) et la résistance ( R3 ).

6. Circuit suivant la revendication 4 ou 5, dans lequel l'entrée de commande du troisième transistor ( T3 ) est reliée à l'entrée de commande du transistor ( T4 ) commandé par la tension par l'intermédiaire d'un deuxième condensateur ( C2 ) et dans lequel une résistance ( R6 ) est montée en parallèle avec le deuxième condensateur ( C2 ) pour augmenter la résistance aux parasites.

7. Circuit suivant la revendication 6, dans lequel une première diode ( D3 ) est, pour décharger le deuxième condensateur ( C2 ), montée entre l'entrée de commande du troisième transistor ( T3 ) et le premier potentiel ( + ) d'alimentation.

8. Circuit suivant l'une des revendications précédentes,
dans lequel une deuxième diode ( D2 ) est, pour décharger le premier condensateur ( C1 ), montée entre l'entrée de commande du deuxième transistor ( T2 ) et le premier potentiel ( + ) d'alimentation.

9. Circuit suivant l'une des revendications précédentes,
dans lequel une résistance ( R2 ) est montée entre le premier potentiel d'alimentation et l'entrée de commande du deuxième transistor ( T2 ).

10. Circuit suivant la revendication 3, également en combinaison avec une autre des revendications précédentes, comprenant un quatrième transistor ( T5 ), dont la section de commutation est montée entre l'entrée de commande du transistor ( T4 ) commandé par la tension et le deuxième potentiel ( - ) d'alimentation, dans lequel l'entrée de commande du quatrième transistor ( T5 ) est reliée à la sortie open-collector de l'amplificateur ( OP ) opérationnel, de façon à pouvoir mettre en circuit la sortie open-collector du quatrième transistor ( T5 ) pour recharger, dans le deuxième sens restant par l'intermédiaire de la section de commande du quatrième transistor ( T5 ), l'entrée de commande du transistor ( T4 ) commandé par la tension.

11. Circuit suivant l'une des revendications précédentes, comprenant une troisième diode ( D1 ), dans lequel le circuit est conçu pour relier par une section de commutation la troisième diode ( D1 ) entre l'entrée de commande du transistor ( T4 ) commandé par la tension et le deuxième potentiel d'alimentation pour recharger dans le deuxième sens restant cette entrée de commande.

12. Circuit suivant la revendication 11 et l'une des revendications 4 à 8, également en combinaison avec une autre des revendications précédentes, dans lequel au moins un transistor du groupe composé du premier ( T1 ), du deuxième ( T2 ), du troisième ( T3 ) et du quatrième transistors ( T5 ) est un transistor bipolaire.
